# EUROPEAN PATENT APPLICATION

(11) **EP 4 550 392 A1**
(43) Date of publication of application: **07.05.2025**
(21) Application number: 23220080.8
(22) Date of filing: 22.12.2023
(51) Int. Cl.: H01L 21/673

(54) **STORAGE SYSTEM FOR SEMICONDUCTOR PRODUCTION OBJECTS AND STORAGE MODULE**

(30) Priority: 06.11.2023 EP 23208054
(71) Applicant: Brooks Automation (Germany) GmbH, 78256 Steißlingen (DE)
(72) Inventor: SCHWETZ, Michael, 8400 Winterthur (CH); Schmidt, Alexander, 8203 Schaffhausen (CH)
(74) Representative: Dehns Germany Partnerschaft mbB

(57) **Abstract**

Provided is a storage system for semiconductor production objects, comprising a plurality of storage modules (2), each storage module having a housing (6) and configured to accommodate at least one semiconductor production object in an interior of the housing; and a stocker comprising a compartment (40), which includes a plurality of storage shelves each configured to receive one or more of the storage modules (2); characterised in that each of the storage modules (2) includes a monitoring device (4) arranged at the housing, the monitoring device having one or more sensors (22, 24, 26), configured to measure one or more parameters in the interior of the housing (6) to determine measurement values, and a communication assembly (12, 14), configured to transmit measurement data including one or more of the measurement values and/or including values derived from the measurement values to an exterior of the housing using a determined data communication method.

## Description

The present invention relates to a storage system for semiconductor production objects, such as reticles or semiconductor wafers, and to a storage module for semiconductor production objects.

### Background

Photolithography processes are widely used as one of the key steps in the manufacture of integrated circuits (ICs) and other semiconductor-related devices and/or structures. In photolithography, a geometric pattern is transferred from a photomask (typically referred to as reticle) onto a substrate, for example a semiconductor wafer, by the use of light, a photosensitive layer and a subsequent etching step. The geometric pattern corresponds to structures of ICs that are obtained from the substrate. Depending on the desired feature size on the substrate, the feature size of the reticle needs to be adapted as well as the wavelength of the light used for pattern transfer, with consideration of the Rayleigh criterion.

As the dimensions of features produced by such processes decrease, the requirements for photolithography for the production of miniature ICs or other devices and/or structures rises. Any contamination of the reticle may reduce the imaging performance of the photolithographic process, e.g. resulting in a higher number of defective ICs on a wafer, and may in more serious cases require the reticle to be replaced. The reticle is typically expensive and therefore any reduction in the frequency with which it must be cleaned or replaced is advantageous. Furthermore, replacement of the reticle is a time consuming process, during which the photolithographic process may have to be suspended, thereby reducing its efficiency, which is undesirable.

Similarly, any contamination of the substrate, e.g. semiconductor wafer, may result in defects of one or more ICs obtained from the substrate.

For example, the use of extreme ultraviolet (EUV) radiation, i.e. electromagnetic radiation having a wavelength within the range of 5-20 nm, has been proposed in order to achieve a smaller feature size. For EUV applications, particle contamination with particle sizes of less than 10 nm as well as chemical contamination, for example by adsorption of volatile organic compounds, can be relevant.

In order to avoid such contaminations and also to avoid mechanical damage of reticles and wafers, storage modules (also called pods) are used, in which single (or a low number of) reticles or wafers are stored. The storage modules are typically stored in storage devices (also called storage stocker or stocker), which have a handling system that comprises as a robot or robot arm, to place and remove storage modules in/from a storage area inside a housing of the storage device or to transfer substrates (e.g. reticles and/or wafers) to/from storage modules. In the housing of the storage device fixed or moveable shelves i.e. support elements, are provided, in which the storage modules can be placed. Each of the shelves may be adapted to receive a single storage module or to receive several storage modules, which are stacked (by the handling system) on each other, for example. Moveable support elements may be arranged on a rotatable carousel or in a paternoster like fashion, for example.

Typically, a purge gas flow is provided by the stocker, which, through appropriate pipes, ducts and openings in the storage modules, is guided through the storage modules, to avoid contaminations and to provide a defined storage environment for the reticles or wafers. One or more mass flow meters may be provided to measure the amount of purge gas. In particular, one mass flow meter may be provided for each storage module.

In a stocker that is configured for storing a high number of storage modules (e.g. several dozen or more), the provision of mass flow meters is relatively complex and costly, as an equally high number of expensive flow meters, complex cabling and extensive assembly work is required.

### Summary

The present invention addresses these problems by providing a storage system for semiconductor production objects and a storage module for semiconductor production objects according to the independent claim. Advantageous embodiments and additional features are provided in the dependent claims and further discussed in the following description.

A storage system for semiconductor production objects is provided, that comprises a plurality of storage modules for accommodating semiconductor production objects and a stocker comprising a compartment with storage shelves for receiving one or more of the storage modules. Each of the storage modules includes a monitoring device arranged at a housing of the storage module, the monitoring device having one or more sensors, configured to measure one or more parameters in the interior of the housing to determine measurement values, and a communication assembly, configured to transmit measurement data including one or more of the measurement values and/or including values derived from the measurement values to an exterior of the housing using a determined communication method.

The storage system according to the invention is advantageous as it enables a direct monitoring of parameters in the environment of reticles or wafers that are stored in the interior of storage modules. Individual flow meters for providing defined flow of purge gas to each storage module are not necessary.

The term 'measurement values' refers to measured values of the (physical or chemical) parameter (i.e. quantity) that is measured by a respective sensor. The term 'measurement data' refers to data that includes one or more of the measurement values (that are measured by the one or more sensors) and/or values (or data) derived from measurement values. Values derived from measurement values include values that are obtained by applying a function or mapping to measurement values. Examples for functions or mappings are a filter, which is applied to the measurement values of a sensor, the determination an extreme value (such as a maximum or minimum) of the measurement values of a sensor, or the determination an average value of the measurement values of a sensor.

The arrangement of a monitoring device at the housing of the respective storage module may be implemented in different ways. For example, the monitoring device can be attached to an inside surface of a wall the housing or can be at least partially embedded in the wall, such that the one or more sensors are exposed to the interior of the housing. Also, the monitoring device may be attached to or at least partially embedded in a part of the storage module that is inside the housing, such as a support element for holding a semiconductor fabrication object or a supply line or pipe or exhaust duct for purge gas.

The "storage shelves" are also denoted as "shelves" in the description. The storage shelves may have fixed positions in the compartment or may be moveable between different positions in the compartment (e.g. in a carousel or paternoster like manner).

According to an embodiment, the storage system further comprises a reading device configured to perform the communication method and to receive the measurement data. In particular, the stocker is provided with the reading device. This allows for a communication of measurement data to the reading device during storage of the storage module in the stocker and/or when placing or removing the storage module in/from the stocker.

According to an embodiment, the data communication method is radio frequency communication. In particular, according to an embodiment, the radio frequency communication is near field communication, NFC, or radio frequency identification, RFID, communication. These communication methods are advantageous since they allow to supply power to the monitoring devices by so-called energy harvesting in a contactless manner. Radio frequency communication by NFC further is short range, such that no or less (than other radio frequency communication methods) radiation is radiated into the interior of the housing, which radiation could harm reticles, for example.

According to an embodiment, the determined data communication method is wired communication, wherein the communication assembly includes electrical contacts and/or pins that are provided on an outer surface of the housing. These contacts and/or pins are connected with electrically conductive lines (wires) which extend through the housing of the storage module, for example. Transfer of energy (similar to energy harvesting) may be done via the contacts and/or pins.

According to an embodiment, the one or more sensors comprise at least one of a pressure sensor, a gas sensor, a temperature sensor, a humidity sensor, acceleration sensor, an electrostatic field meter. These sensors or combinations thereof allow the monitoring of parameters that are particularly relevant for avoiding contamination and damage of objects stored in storage modules. It will be appreciated that one or more other than the mentioned sensors or additional one or more sensors may be used as well, examples are a light sensor and/or a photodetector and/or a magnetometer and/or other types of sensors.

According to an embodiment, the stocker includes a handling device for carrying storage modules in order to place and remove the storage modules on or from the storage shelves wherein the reading device includes an antenna that is positioned on the handling device, such that, when the handling device is carrying a storage module, the radio frequency communication possible. Particularly, the reading device is configured to establish the radio frequency communication, when one of the storage modules is carried by the handling device. Such an arrangement facilitates retrofitting already existing storage systems, by attaching monitoring devices in already present storage modules and attaching the reading device to the handling device.

According to an embodiment, the stocker includes a handling device for carrying semiconductor production objects in order to place and remove the semiconductor production objects in or from storage modules, wherein the reading device includes an antenna that is positioned on the handling device, such that, when the handling device is accessing the storage module, the radio frequency communication possible. In particular, the handling device is configured for carrying semiconductor production objects (reticles or wafers) in order to move these objects between the storage modules and other locations like load ports. Particularly, the reading device is configured to establish the radio frequency communication, before and/or during and/or after a substrate is picked or placed from a storage module. Such an arrangement facilitates retrofitting already existing storage systems, by attaching monitoring devices in already present storage modules and attaching the reading device to the handling device.

According to an embodiment, the stocker has a load port for storage modules; and wherein the reading device is arranged at the load port. Accordingly, it is possible to monitor the interior of storage modules immediately after or before use of the semiconductor fabrication object stored in the storage modules.

According to an embodiment, the communication assembly of each monitoring device is configured to receive power by harvesting energy from radio frequency electromagnetic fields and to supply the power to the monitoring device, wherein the storage shelves are moveable between different positions in the compartment, wherein the different positions include at least one charging position, wherein in proximity to the at least one charging position at least one charging device is arranged in the compartment, which is configured to generate a radio frequency electromagnetic field, wherein the monitoring devices and the at least one charging device are arranged in the storage modules and in the compartment, respectively, such that, when a storage shelf is at a charging position, power supply is possible from the charging device to the communication assembly of a monitoring device of a storage module that is placed on the storage shelf. The provision of charging devices allows the measuring of the parameters over extended periods of time or even permanently.

According to an embodiment, the communication assembly of each monitoring device is configured to receive power by harvesting energy from radio frequency electromagnetic fields and to supply the power to the monitoring device, in particular to the one or more sensors. This allows to power the monitoring devices and to charge an energy storage of the monitoring devices, if included.

According to an embodiment, the storage shelves are moveable between different positions in the compartment, wherein the different positions include at least one reading position, wherein in proximity to the at least one reading position at least one reading device is arranged in the compartment, which is configured for the radio frequency communication, wherein the monitoring devices and the at least one reading device are arranged in the storage modules and in the compartment, respectively, such that, when a storage shelf is at a reading position, radio frequency communication is possible between the reading device and the communication assembly of a monitoring device of a storage module that is placed on the storage shelf. Accordingly, the measuring of the parameters and transmission of measurement data over extended periods of time or even permanently (if the reading devices supply power to the monitoring modules by energy harvesting) is possible.

According to an embodiment, wherein each of the monitoring devices includes a controller configured to receive and/or pass through measurement values and to control the communications assembly to transmit the measurement data. The controller may further control the one or more sensors or forward the communication to the sensors.

According to an embodiment, the controller of each of the monitoring devices is configured to apply a function to the measurement values in order to obtain the values derived from the measurement values. By applying a function to the measurement values, the amount of data that is to be transmitted as measurement data can be reduced, as highly relevant values, such as extreme values or average values can be determined and transmitted, while other data, e.g. the raw data of measurement values, may be discarded.

According to an embodiment, the controller of each of the monitoring devices has access to at least one memory that is included in the controller or provided externally of the controller on the monitoring device, wherein the at least one memory includes a volatile and/or a non-volatile memory. Accordingly, the measurement data can be stored for later transmission in the memory during periods of time, in which no reading device is present.

According to an embodiment, each of the monitoring devices includes an energy storage element. Accordingly, components of the monitoring devices can be provided with power during periods of time, in which no reading device or charging device provides power through a radio frequency electromagnetic field.

According to an embodiment, the storage system comprises a control unit configured to receive the measurement data from the reading device. The control unit may further be configured to analyse the measurement data, e.g. if measurement values or derived values are in predefined ranges, and, when the analysis indicates an abnormal environment in the interior of a storage device, e.g. if the measurement values or derived values are outside the predefined ranges, perform or cause a predefined action. The predefined action is for example, sending an error message to a controller of the production facility in which the storage system is used, adjusting a flow of purge gas, or similar actions.

According to another aspect of the present invention a storage module for semiconductor production objects is provided, comprising a housing and configured to accommodate at least one semiconductor production object in an interior of the housing; and adapted to be received in a storage shelve of a stocker compartment and/or adapted for transportation outside of a stocker compartment; wherein the storage module includes a monitoring device arranged at the housing, the monitoring device having one or more sensors, configured to measure one or more parameters in the interior of the housing to determine measurement values, and a communication assembly, configured to transmit measurement data including one or more of the measurement values and/or including values derived from the measurement values to an exterior of the housing using a determined data communication method. Transportation of the storage module (and of at least one semiconductor production object, when accommodated in the storage module) outside of a stocker compartment may, for example, take place between various production tools in a semiconductor fabrication facility and/or between the stocker and such a production tool. A storage module that is adapted for transportation can also be denoted as transport module or transport pod. It will be appreciated that any feature that is related to the storage module as such (e.g. structure of the monitoring device, type of sensor, type of the communication method, energy storage element, memory) and that is described with respect to the storage system in this disclosure is also applicable to the transport module.

### Brief description of the drawings

Advantages and further aspects of the invention will now be discussed further with reference to the appended drawings.
Figure 1 shows a storage module according to embodiments of the invention.
Figures 2A, 2B show monitoring devices according to embodiments of the invention.
Figures 3A, 3B show a handling robot that is equipped with a reading device according to an embodiment of the invention.
Figures 4A, 4B partially show stockers according to embodiments of the invention.

### Detailed description of the drawings

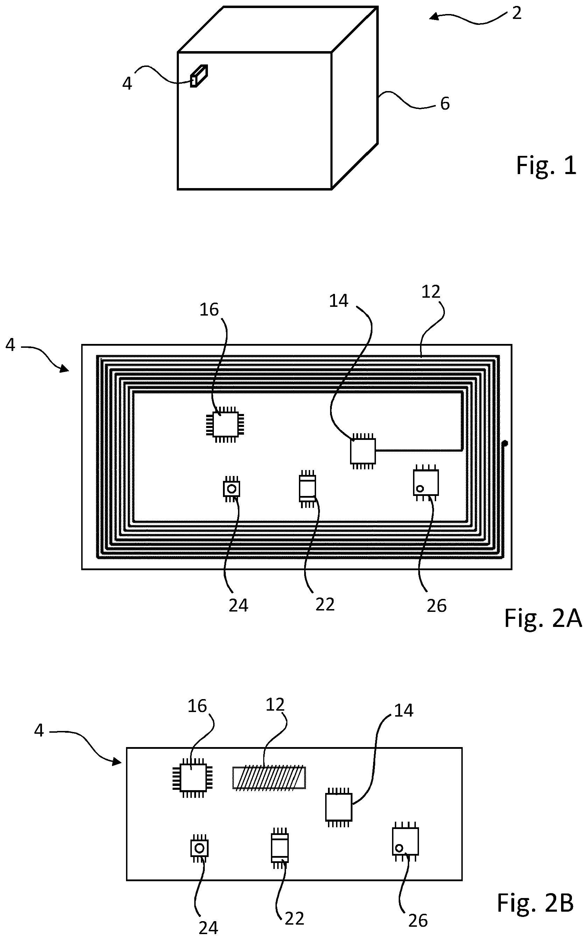

Figure 1 shows a storage module 2 according to embodiments of the invention in a schematic manner.

The storage module 2 comprises a housing 6 with several walls which enclose an interior of the storage module. For example, the storage module 2 has a cuboid form, but may in general have another form, shape or consist of several parts. The interior of the storage module 2 is configured to accommodate at least one semiconductor production object, such as a reticle (photomask) or a semiconductor wafer. For example, the storage module 2 has one or more support elements which are integrated and/or attached to the walls and are configured to receive and fixedly handle a semiconductor production object. At least one of the walls or parts may be at least partially removeable, for example be configured as a door, such that the interior can be accessed for placing and removing semiconductor production objects in or from the interior of the storage element, e.g. on or from the support elements. The support elements and semiconductor production objects are not shown in Figure 1 for simplicity. Further, the storage module 2 may include a supply line and/or an exhaust duct for supplying a purge gas to the interior and discharging the purge gas from the interior. The supply line and/or the exhaust duct are, for example, configured to be coupled with supply lines and/or exhaust lines provided in a stocker in which the storage module may be accommodated or stored.

The storage module 2 includes a monitoring device 4 that is arranged at the housing 6. According to an embodiment, the monitoring device 4 is attached to an inner side face of one of the walls of the housing 6 of the storage module, i.e. to a surface of a wall facing the interior of the storage module. According to other embodiments, the monitoring device is at least partially embedded in a wall of the housing, e.g., in a recess or opening formed in the wall. According to further embodiments, the monitoring device is arranged on another element (other than a wall) of the storage module, such as on a support element or the supply line and/or the exhaust duct.

The monitoring device 4 includes one or more sensors (not shown in Figure 1; cf. Figures 2A, 2B for exemplary embodiments), which are configured to measure one or more parameters. The one or more sensors are arranged on the monitoring device 4, such that they measure the respective parameter in the interior of the storage module 2, in order to obtain measurement values for the respective parameter. According to embodiments, the one or more sensors include at least one of a temperature sensor, a humidity sensor, a gas sensor, an acceleration sensor, a pressure sensor, an electrostatic field meter.

The monitoring device 4 further includes a communication assembly which is configured to transmit and receive data to and from devices on an outside of the housing of the storage module. The transmitted data includes measurement data, i.e. measurement values and/or values derived from the measurement values obtained by the one or more sensors. The received data may include command messages, i.e. configuration commands or control commands. The data may further include a unique identification of the monitoring device, which may also be used to identify the storage module 2. More generally, the communication assembly is configured to communicate with devices outside the housing, i.e. to transmit and receive data to/from the outside.

According to embodiments of the invention, the transmission or communication of data is performed wirelessly, i.e. using radio frequency communication by a radio frequency electromagnetic field, such as radio wave communication and/or communication by electromagnetic fields. A frequency of the electromagnetic field may be in the range from 3 MHz to 30 GHz, in particular in the range from 3 MHz to 30 MHz. For example, communication by electromagnetic fields is achieved by near field communication (NFC). NFC refers to communication by electromagnetic fields over short distances, i.e. less than 10 cm or less than 5 cm. A frequency used in NFC is 13.56 MHz, for example. More generally, techniques known from RFID (radio frequency identification) may be used. Radio wave communication may be achieved by Bluetooth, WiFi, or the like, having operating frequencies of several GHz. Alternative to wireless communication using radio frequency communication, another data communication method is a wired communication. That is, the monitoring device may be configured to transmit or communicate data in a wired manner, e.g., electrically conductive lines may be guided through a wall of the housing and be in connection with electrical contacts and/or electrical pins on the outer surface of the housing. Such electrical contacts and/or electrical pins may be part of a communication terminal, e.g. an adapter or plug. The electrical contacts and/or electrical pins (and the electrically conductive lines) may be seen as part of the communications assembly.

Figures 2A, 2B show monitoring devices 4 according to exemplary embodiments of the invention.

For each of the two embodiments, the monitoring device 4 comprises a temperature sensor 22, a humidity sensor 24 and a gas sensor 26 (for measuring the concentration of certain gases), for example. As noted above, generally a monitoring device includes one or more sensors. Examples for other potential sensor types are a shock sensor (e.g. in the form of an acceleration sensor), an electrostatic field meter, and a pressure sensor.

The monitoring device 4 comprises a communication assembly, which includes an antenna 12 and a communication control device 14, such as an NFC chip. The communication assembly is configured to perform radio frequency communication, in particular to transmit or communicate measurement data.

Optionally, as shown in Figures 2A, 2B, the monitoring device 4 comprises a controller 16. Further, optionally, the monitoring device 4 comprises an energy storage element (not shown), such as a battery, an accumulator, or a capacitor. Such an energy storage element may be provided as a separate external component or may be included in one of the other components, e.g. the communication control device 14 or, as dedicated component mounted on the monitoring device 4. The components (sensors, communication assembly, controller) of the monitoring device are mounted on a substrate, such as a printed circuit board (PCB), for example. Some of the components may be mounted on a surface of the substrate or PCB as surface mounted devices (SMD).

The one or more sensors 22, 24, 26 are mounted on the substrate or PCB, such that they are able to measure the respective parameter (which is measured by one of the sensors) in the interior of the storage module, when the monitoring device 4 is mounted in the storage module. For example, if the monitoring device 4 is attached to a wall of the storage module 2 as shown in Figure 1, the sensors are typically arranged on the side of the monitoring device 4 which is opposite to the side attached to the wall. The one or more sensors 22, 24, 26 are configured to transmit measurement values (of the parameters) to the communication control device 14 and/or, if present, to the controller 16. The one or more sensors 22, 24, 26 may be provided with power by the communication control device 14 and/or, if present, the energy storage element and/or, if present, the controller 16.

The communication control device 14 is configured to transmit and, optionally, receive data using the antenna 12. The data is in particular measurement data, e.g. measurement values and/or data derived from the measurement values. Further, the monitoring device 2 may have a unique identification code, which is stored in the communication control device 14 (or the controller 16) and which is transmitted by the communication control device 14 to a reader device.

The communication control device 14 may further be configured to draw power from the antenna 12 when a radio frequency electromagnetic field (of sufficient field strength) is present that induces electrical currents in the antenna (so-called energy harvesting). The radio frequency electromagnetic field is generated by a reading device or a charging device in proximity to the antenna 12 of the monitoring device 4, in particular when NFC or RFID communication is used. The power received by the communication control device 14 in this manner may be used directly to power the communication control device 14, the one or more sensors 22, 24, 26, and, if present, the controller 16. Alternatively or additionally, the power received by the communication control device 14 may be used to charge the energy storage element (if included in the monitoring device). The energy storage element may then provide power to the components of the monitoring device, i.e. to the communication control device 14, the one or more sensors 22, 24, 26, and, if present, the controller 16.

The controller 16 (if included in the monitoring device 4), e.g. a micro controller, is configured to control the one or more sensors 22, 24, 26 and/or the communication control device 14. The control of the one or more sensors 22, 24, 26 may include setting a measurement frequency and/or setting points in time for measurements. The controller 16 may further be configured to receive measurement values from the sensors. The received measurement values (generally denoted as measurement data) are then transmitted to the communication control device 14 for being transmitted over the antenna as measurement data. Alternatively or additionally, the controller 16 applies at least one function to the received measurement values in order to obtain values (or data) derived from the measurement values, which is transmitted to the communication control device 14 for being transmitted over the antenna as measurement data. The at least one function, which is applied to the measurement values is for example a filtering of measurement values, a determining of an average of measurement values, a determining of an extreme value of the measurement values (such as a maximum and/or a minimum), or the like. The controller may be programmable and/or include a volatile memory and/or include a non-volatile memory. Such a volatile memory and/or a non-volatile memory may be provided on a memory chip external to the controller.

In embodiments that do not include an energy storage element in the monitoring device 4, the communication control device 14 is configured to automatically provide power harvested from a radio frequency field (i.e. received through the antenna) to the one or more sensor and, if present, the controller 16. The one or more sensors may be configured to, as soon as sufficient power is provided, take measurements and transmit measurement values to the communication control device 14, which in turn transmits the measurement values as measurement data. In case controller 16 is included in the monitoring device 4, the controller 14 may also start to perform its operation as soon as sufficient power is provided.

In embodiments, in which an energy storage element is included in the monitoring device 4, the energy stored therein may be used to power the one or more sensors 22, 24, 26 and the controller 16 and optionally the communication control device 14 during time periods in which no radio frequency field is present at the antenna (or the field is insufficient to power the components of the monitoring device) or if the communication assembly is not configured to harvest energy. Accordingly, during such time periods, the one or more sensors 22, 24, 26 may take measurements and the controller 14 may perform its operation, e.g. at least one of controlling the sensors, receiving measurements values from the sensors, applying a function to the measurement values to determine values derived from measurement vales, and storing the measurement data obtained in this manner in a volatile memory and/or a non-volatile memory of the controller. The stored measurement data (measurement values and/or values derived from measurement values) is transmitted by the communication assembly when or as soon as a reading device is communicatively connected.

In embodiments, in which no energy storage element is included in the monitoring device 4, but in which power is provided by a charging device (having no reading functionality) during certain periods of time, the controller 16 includes a non-volatile memory. During said periods of time, the sensors 22, 24, 26 and the controller may be configured to perform their operation as described above using energy harvested from the charging device. Further, during said periods of time, the measurement data and/or the data derived from measurement data is stored in the non-volatile memory by the controller, and the stored measurement data is transmitted by the communication assembly when a reading device is communicatively connected at a later time.

The embodiments of Figures 2A and 2B are different in that different antennas are used. In the embodiment of Figure 2A, the antenna 12 is printed (e.g. in the form of spirally arranged electrical conducting lines) on the substrate or PCB or on a non-conducting foil to which the substrate or PCB is attached, such that the monitoring device is relatively flat (compared to the embodiment of Figure 2B), i.e. its extension in vertical direction (perpendicular to the drawing plane) is relatively small. In the embodiment of Figure 2B, the antenna 12 is a coil antenna is mounted on a surface of the substrate or PCB (SMD coil antenna), such that the monitoring device has a relatively footprint (compared to the embodiment of Figure 2B), i.e. its area (parallel to the drawing plane) is relatively small.

It will be appreciated that, if wired communication is used as communication method, instead of an antenna electrical contacts and/or electrical pins are provided that are electrically connected to the communication control device, e.g. by electrically conductive lines extending through the housing of the storage module.

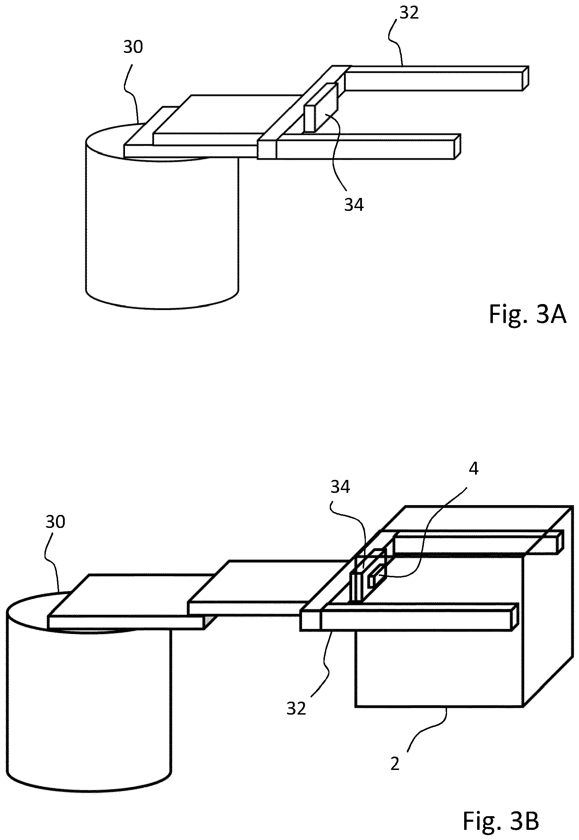

Figures 3A, 3B show a handling robot 30 that is equipped with a reading device 34 according to an embodiment of the invention.

The handling robot 30 is used to place and remove storage modules 2 from storage shelves (also denoted as shelves) of a storage device (stocker) or semiconductor production objects (such as reticles, wafers or substrates) to/from the storage device. The handling robot 30 is, for example, configured to carry storage modules 2 between shelves of the stocker and a load port (i.e. an input and/or output area) of the stocker. To that end, the handling robot 30 includes a carrying element 32, which is attached to an extendible arm of the handling robot 30. The extendible arm may be mounted on a rotatable support. The carrying element 32 is configured to pick up storage modules and to carry at least one storage module 2, as shown in Figure 3B. For example, the carrying element 32 is a gripper that includes movable gripping elements. In another example, the carrying element 32 includes holding elements, which are formed to engage with complementary formed elements on the outer surface of the storage modules. The storage module comprises a monitoring module 4 as described in relation to Figures 1, 2A and 2B.

A reading device 34 is attached at a determined position of the handling robot 30, more specifically at a determined position of the carrying element 32. The reading device 34 is configured to perform wireless communication using radio frequency electromagnetic fields. The type of wireless communication (i.e. the frequency, communication protocol) is the same as that of the monitoring module 4 included in the storage modules 2. The position at which the reading device 34 is determined such that, when a storage module 2 is carried by the carrying element 32, wireless communication is possible between the reading device 34 and the monitoring module 4 of the carried storage module 2. That is, the position of the reading device 34 on the handling robot 30 or the carrying element 32 and the position of the monitoring device 4 in the storage module 2 correspond to each other, such that wireless communication is possible between the reading device 34 and the monitoring module 4 when the storage module 2 is carried by the carrying element. The shown embodiment is particularly suitable, if a communication method with relatively low range is used. If, for example, NFC is used as communication protocol, the positions of the reading device on the handling robot and the monitoring device should be determined such that, when the storage module is carried by the carrying element, a distance between the reading device and the monitoring device is less than 10 cm or less than 5, in particular less than 4 cm. This can be achieved by arranging the reading device at a position on the handling robot which is in proximity to a wall of the storage module on which the monitoring device is attached. For example, the reading device is arranged on the carrying element, as shown.

The reading device 34 is configured to receive measurement data from the monitoring device. Further, the reading device may transmit (in a wired or wireless manner) the received measurement data to a control unit of the stocker, in which the handling robot is included.

Additionally, the reading device 34 is optionally configured, such that the radio frequency electromagnetic field generated by the reading device (i.e. by an antenna thereof) is strong enough in order to allow the communication assembly of a monitoring device to harvest energy from the field when the storage module (that includes the monitoring device) is carried by the carrying element.

It will be appreciated that, if wired communication is used as communication method, the reading device is configured to perform wired communication (instead of wireless communication). In this case, the reading device includes electrical pins and/or electrical contacts which correspond (i.e. which are complementary) to the electrical contacts and/or electrical pins of the monitoring devices of storage modules, such that when the handling robot (i.e. its carrying element) is carrying (holding) a storage module the electrical pins and/or electrical contacts of the reading device are in contact with the electrical contacts and/or electrical pins of the monitoring device of the carried storage module.

It will further be appreciated that different from the embodiment shown in Figure 3B (in which the handling robot is configured to carry storage modules), the handling robot may be configured to pick up, carry and place semiconductor fabrication objects (such as reticles or wafers). Particularly, the handling robot may be configured to pick up a semiconductor fabrication object at one location, such as a load port, carry the object to a storage module, and place the object in the storage module, and may for be configured to pick up a semiconductor fabrication object from a storage module, carry the object to another location, such as the load port, and place the object at this location. In this embodiment the reading device is arranged at the handling robot and the monitoring device is arranged at the storage module, such that before and/or during and/or after the picking up or placing of the semiconductor fabrication object the communication between the reading device and the monitoring device is possible. If wireless communication is used, in particular NFC or RFID communication, the periods of time specified as "before" and/or "during" and/or "after" refer to periods of time during which the reading device is close enough to the monitoring device, such that the wireless communication is rendered possible.

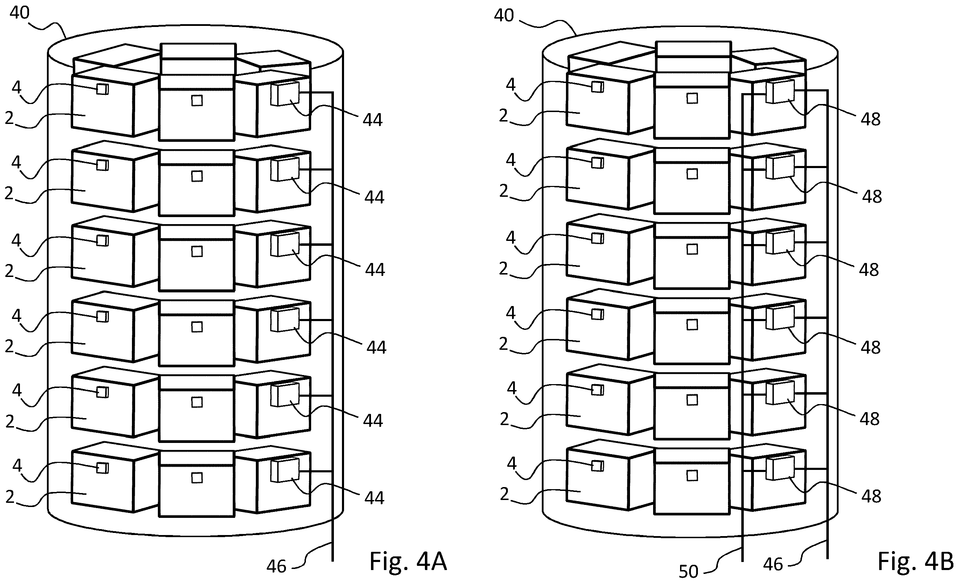

Figures 4A, 4B partially show stockers (i.e. storage devices or storage facilities) for storage modules according to embodiments of the invention.

The stockers of both embodiments comprise a compartment 40, in which a plurality of shelves for storage module is provided. The shelves are arranged in columns (six in the illustrated example) that are rotatable around a vertical axis, i.e. a carousel type storage is formed (this structure, formed by the shelves and the axis is not shown). As shown, storage modules 2 having a monitoring device 4 (both provided with reference signs for one column only) are placed on the shelves (e.g. all shelves or essentially all shelves are occupied). In a wall of the compartment 40 at least one opening or at least one door is arranged (not shown, for example positioned on the rear side in the perspective view of the figures) through which the storage modules 2 can be placed into the compartment and removed from the compartment. For example, a handling robot similar to the one shown in Figures 3A, 3B and additionally configured to move its arm and/or carrying element vertically is provided on the outside at the location of the at least one opening or at least one door, in order to place and remove storage modules in or from the compartment and the shelves provided in the compartment.

Referring to Figure 4A, a column of charging devices 44 is arranged on the wall of the compartment 40. Each charging device 44 generates, by an antenna, a radio frequency electromagnetic field, which is suitable (in particular strong enough) to provide power to monitoring devices, i.e. which is suitable for energy harvesting by monitoring devices or their communication assembly. The charging devices 44 are supplied with power by a power line 46. The columns of shelves and therefore the storage elements are rotatable around the vertical axis, such that at a certain position (also denoted charging position) the storage modules 2, specifically the monitoring devices 4 included in the storage modules 2, are at positions which enables energy harvesting, i.e. transfer of energy from the charging devices 44 to the monitoring device. As explained, this is possible if the distance between the positions of the monitoring devices and of the charging devices is short enough.

The charging devices 44 are not able to communicate wirelessly with the monitoring device and may therefore not read or receive measurement data from the monitoring devices. The reading of measurement data is done by at least one reading device positioned at a different part of the stocker. For example (as shown in Figures 3A, 3B), a reading device 34 is arranged on a carrying device 32 of the handling robot 30 which places and removes storage modules from the compartment and the shelves therein. In case the monitoring devices include no energy storage element, the one or more sensors of the monitoring devices may take measurements during periods of time in which the respective monitoring module is supplied with power by a charging device (i.e. when the storage module is at a charging position), wherein the measurement data (measurement values and/or values derived from the measurement values) is stored in a non-volatile memory of the controller. In case the monitoring devices include an energy storage element, the one or more sensors of the monitoring devices may essentially continuously (or at least for longer time periods than the time during which the storage module is at a charging position) take measurements, wherein the measurement data is stored in a memory (volatile or non-volatile) of the controller. In the latter case, a rotation scheme of the columns of the stocker may be devised such that the energy storage elements of the monitoring devices retain sufficient power during time periods where the monitoring module is not charged, for example.

Referring to Figure 4B, a column of reading devices 48 (instead of charging devices 48 as in Figure 4A) is arranged on the wall of the compartment 40. The reading devices 48 are capable of receiving (reading) measurement data from the monitoring modules and to provide energy to the monitoring modules by energy harvesting. The reading devices 48 are connected to a data communication line 50, for communicating data with a control unit of the stocker, and a power line 46, for receiving power. As in Figure 4A, the columns of shelves and therefore the storage elements are rotatable around the vertical axis, such that at a certain position (also denoted reading position) the storage modules 2, specifically the monitoring devices 4 included in the storage modules 2, are at positions which enable communication of data between the reading devices 48 and the monitoring modules 4 as well as energy harvesting, i.e. transfer of energy from the reading devices 44 to the monitoring device.

In the embodiment of Figure 4B, in case the monitoring devices include no energy storage element, the one or more sensors of the monitoring devices may take measurements during periods of time in which the respective monitoring module is supplied with power by a reading device 48 (i.e. when the storage module is at a reading position), wherein the measurement data (measurement values and/or values derived from the measurement values) transmitted to the reading device 48 while at the reading position. In case the monitoring devices include an energy storage element, the one or more sensors of the monitoring devices may essentially continuously (or at least for longer time periods than the time during which the storage module is at a reading position) take measurements, wherein the measurement data is stored in a memory (volatile or non-volatile) of the controller during time periods in which the storage module is not at a reading position. The measurement data is then transmitted to a reading device 48, when the storage module 2 is at a reading position again and/or, if another (additional) reading device (e.g. on a handling robot) is included in the stocker, when the storage module and its monitoring device is in reading distance to that another reading device. In the case of an energy storage element being included in the monitoring device, for example, a rotation scheme of the columns of the stocker may be devised such that the energy storage elements of the monitoring devices retain sufficient power during time periods where the monitoring module is not charged, i.e. when the storage module is not at a reading position.

Referring to Figures 4A and 4B, it will be appreciated that similar configurations (i.e. having charging devices or reading device at certain positions, such as on a wall of the compartment, which are determined such that charging and/or reading monitoring devices is possible if the respective storage modules are at determined positions, such as charging and/or reading positions) are also possible for other types (than carousel type) of stockers having moveable shelves. For example, when the shelves and storage modules are moved in a paternoster like manner.

It will be appreciated that a reading device or charging device may be positioned at other locations than shown in the embodiments of Figures 3A, 3B, 4A and 4B. For example, a reading device may be provided at a load port of the stocker. The load port is an area where storage modules are placed (e.g. after being processed in another part of the production facility in which the stocker is used) in order to be moved to a shelf in the compartment by a handling device, such as a handling robot, or where the handling device places storage modules that have been removed from the compartment by the handling device. In another example, reading devices or charging devices are provided at one or more (or all) of the shelves.

It will further be appreciated that embodiments and/or examples described above may be combined. For example, charging devices may be located at one or more (or all) of the shelves or at a wall of the compartment (as shown in Figures 4A, 4B) and at least one reading device may be located at the load port and/or at the handling device, such as a handling robot.

It will further be appreciated that the term storage modules as used in this specification shall also comprise transport modules (transport pods), i.e. modules for storing semiconductor fabrication objects (e.g. reticle or wafers) during transport, for example for transporting semiconductor fabrication objects between various production tools in a semiconductor fabrication facility. These could also be provided with a monitoring device comprising an energy storage element as described in the present disclosure with respect to storage modules. The measurement data from the monitoring devices could, for example, be read at load ports of such production tools. Such monitoring devices could also be charged by energy harvesting at load ports of production tools.

## Claims

1. A storage system for semiconductor production objects, comprising
a plurality of storage modules (2), each storage module having a housing (6) and configured to accommodate at least one semiconductor production object in an interior of the housing; and
a stocker comprising a compartment (40), which includes a plurality of storage shelves each configured to receive one or more of the storage modules (2);
wherein each of the storage modules (2) includes a monitoring device (4) arranged at the housing, the monitoring device having one or more sensors (22, 24, 26), configured to measure one or more parameters in the interior of the housing (6) to determine measurement values, and a communication assembly (12, 14), configured to transmit measurement data including one or more of the measurement values and/or including values derived from the measurement values to an exterior of the housing using a determined data communication method.

2. The storage system according to claim 1, further comprising a reading device (34, 48) configured to perform the determined data communication method and to receive the measurement data; particularly, wherein the stocker is provided with the reading device.

3. The storage system according to claim 1 or 2, wherein the determined data communication method is radio frequency communication; particularly, wherein the radio frequency communication is near field communication, NFC, or radio frequency identification, RFID, communication.

4. The storage system according to claim 1 or 2, wherein the determined data communication method is wired communication; and wherein the communication assembly includes electrical contacts and/or pins that are provided on an outer surface of the housing.

5. The storage system according to any one of the preceding claims, wherein the one or more sensors (22, 24, 26) comprise at least one of a pressure sensor, a gas sensor, a temperature sensor, a humidity sensor, an acceleration sensor, an electrostatic field meter.

6. The storage system according to any one of the preceding claims, wherein the stocker includes a handling device (30) for carrying storage modules (2) in order to place and remove the storage modules on or from the storage shelves or for carrying semiconductor production objects in order to place and remove the semiconductor production objects in or from storage modules (2); wherein the reading device is arranged on the handling device (30), such that, when the handling device is carrying a storage module (2) or before and/or during/or after picking up or placing a semiconductor production object from or in a storage module, radio frequency communication or wired communication between the one or more sensors and the reading device is rendered possible; and
particularly, wherein the reading device is configured to establish the radio frequency communication or wired communication, when one of the storage modules is carried by the handling device or before and/or during/or after picking up or placing a semiconductor production object from a storage module.

7. The storage system according to any one of the preceding claims, wherein the stocker comprises a load port for storage modules; and wherein the reading device is arranged at the load port.

8. The storage system according to any one of the preceding claims, wherein the communication assembly (12, 14) of each monitoring device (4) is configured to be powered by harvesting energy from radio frequency electromagnetic fields ; wherein the storage shelves are moveable, especially rotatable, between different positions in the compartment (40); wherein the different positions include at least one charging position; wherein in proximity to the at least one charging position at least one charging device (44) is arranged in the compartment, which is configured to generate a radio frequency electromagnetic field; wherein the monitoring devices and the at least one charging device are arranged in the storage modules and in the compartment, respectively, such that, when a storage shelf is at a charging position, power supply is possible from the charging device (44) to the communication assembly (12, 14) of a monitoring device (4) of a storage module (2) that is placed on the storage shelf.

9. The storage system according to any one of the preceding claims, wherein the communication assembly (12, 14) of each monitoring device (4) is configured to receive power by harvesting energy from radio frequency electromagnetic fields and to supply the power to the monitoring device, in particular to the one or more sensors (22, 24 ,26).

10. The storage system according to any one of the preceding claims, wherein the storage shelves are moveable between different positions in the compartment (40); wherein the different positions include at least one reading position; wherein in proximity to the at least one reading position at least one reading device (48) is arranged in the compartment, which is configured for the radio frequency communication; wherein the monitoring devices and the at least one reading device are arranged in the storage modules and in the compartment, respectively, such that, when a storage shelf is at a reading position, radio frequency communication is possible between the reading device (48) and the communication assembly (12, 14) of a monitoring device (4) of a storage module (2) that is placed on the storage shelf.

11. The storage system according to any one of the preceding claims, wherein each of the monitoring devices (4) includes a controller (16) configured to receive and/or pass through measurement values and to control the communications assembly to transmit the measurement data.

12. The storage system according to claim 11, wherein the controller (16) of each of the monitoring devices (4) is configured to apply a function to the measurement values in order to obtain the values derived from the measurement values; and/or wherein the controller (16) of each of the monitoring devices has access to at least one memory that is included in the controller or provided externally of the controller on the monitoring device; wherein the at least one memory includes a volatile and/or a non-volatile memory.

13. The storage system according to any one of the preceding claims, wherein each of the monitoring devices (4) includes an energy storage element.

14. The storage system according to any one of the preceding claims, further comprising a control unit configured to receive the measurement data from the reading device (34, 48); wherein the control unit is configured to analyse the measurement data.

15. The storage system according to claim 14, wherein the control unit is configured to determine if an abnormal environment is present in the interior of a storage device based on the analysis of the measurement data.

16. A storage module for semiconductor production objects, comprising
a housing (6) and configured to accommodate at least one semiconductor production object in an interior of the housing; and
adapted to be received in a storage shelve of a stocker compartment (40) and/or adapted for transportation outside of a stocker compartment (40);
wherein the storage module (2) includes a monitoring device (4) arranged at the housing, the monitoring device having one or more sensors (22, 24, 26), configured to measure one or more parameters in the interior of the housing (6) to determine measurement values, and a communication assembly (12, 14), configured to transmit measurement data including one or more of the measurement values and/or including values derived from the measurement values to an exterior of the housing using a determined data communication method.
